Europäisches Patentamt

(19) European Patent Office

Office européen des brevets

(11) EP 0 774 839 A2

## EUROPEAN PATENT APPLICATION

(12)

(43) Date of publication:
21.05.1997 Bulletin 1997/21

(51) Int. Cl.$^6$: H03M 5/16

(21) Application number: 96116660.0

(22) Date of filing: 17.10.1996

(84) Designated Contracting States:
DE FR GB IT NL

(30) Priority: 19.10.1995 US 5614
19.12.1995 US 8897

(71) Applicant: TEXAS INSTRUMENTS
INCORPORATED
Dallas, Texas 75243 (US)

(72) Inventors:
• Seabaugh, Alan C.
Richardson, TX 75082 (US)

• Taddiken, Albert H.
Farmersville, TX 75442 (US)
• Obeid, Iyad
Cambridge, MA 02139 (US)

(74) Representative: Holt, Michael
Texas Instruments Limited,
Kempton Point,
68 Staines Road West
Sunbury-on-Thames, Middlesex TW16 7AX (GB)

(54) **Negative resistance element for multivalue to binary conversion**

(57) A circuit that can form the core element for analog-to-digital convertors and multi-valued to binary converter circuits is disclosed. The circuit has an input transistor 20 coupled to receive an input signal $V_{IN}$. A first negative-resistance element 22, RTD couples between the output electrode $V_{OUT}$ of the input transistor 20 and a positive voltage source. A second negative-resistance element 3RTD couples between the input transistor 20 and ground. The peak to valley current ratio of the first negative-resistance element 22,RTD is selected to be less than the peak to valley current ratio of the second negative-resistance element 3RTD. The circuit functions to convert inputs at varying voltages (multi-valued) to two levels at the output $V_{OUT}$.

Fig. 4

## Description

### FIELD OF THE INVENTION

This invention relates generally to a electrical circuit having a combination of a negative resistance device, such as a tunnel diode, and a transistor which, when used together, comprise a high speed switching load circuit with a range of uses including arithmetic logic circuits and analog-to-digital conversion.

### BACKGROUND OF THE INVENTION

In the field of digital logic and other circuits, a principal thrust of development for engineers in recent years has been to produce circuits which run faster than earlier developed circuits. An additional emphasis of design engineers has been the attempt to reduce circuit power consumption. This latter objective, however, has not always been achieved because faster circuits often result from new circuit designs that use more transistors than prior slower circuits and, with a greater number of transistors, the power consumption of the new design is usually higher than that of the earlier design.

Another major thrust of circuit developers and device designers has been to reduce the physical size or "footprint" of newer circuits. This emphasis has been driven by various market forces which demand miniaturization of circuits. Reducing circuit size in some instances serves to reduce power consumption as well. However, the increased number of circuits in some faster designs has often more than offset the power savings resulting from smaller sized devices.

### BRIEF DESCRIPTION OF THE INVENTION

In view of the above stated difficulties experienced by prior art circuits, it is a primary objective of the present invention to provide a circuit usable in logic and analog to digital converters which is physically smaller than prior art devices.

It is a further objective of this invention to provide a circuit usable in logic and analog to digital converters which consumes less power than prior art devices.

It is still another objective of the invention to provide a circuit usable in logic and analog to digital converters which will function at very high speeds.

In achieving these and other objectives, the present invention includes a transistor with two controlled electrodes shunted by a resonant tunneling diode and the control electrode of the transistor coupled to one of the controlled electrodes. A second transistor has one of its controlled electrodes coupled to the control electrode of the first transistor and its other controlled electrode coupled to at least two series connected resonant tunneling diodes. The control electrode of the second transistor comprises the circuit input node and the control electrode of the first transistor is coupled to the circuit output node. This configuration comprises a circuit suitable for high speed logic and analog to digital applications as it accepts a multi-valued input voltage and produces in response thereto, a binary output voltage.

### BRIEF DESCRIPTION OF THE DRAWINGS

The present invention will now be further described, by way of example, with reference to the accompanying drawings in which:

Fig. 1 illustrates the typical I-V relationship for a negative-resistance device such as a resonant tunneling diode;

Fig. 2 illustrates the typical I-V characteristic for a high speed negative-resistance device with low current hysteresis;

Fig. 3 illustrates the I-V characteristic of a transistor and resonant tunneling diode coupled in parallel;

Fig. 4 illustrates a form of the circuit according to the present invention which utilizes FET transistors;

Figs. 5(a)-5(d) illustrate the operation of the circuit of Fig. 4;

Fig. 6(a) illustrates a portion of the circuit of Fig. 4 with Schottky diodes coupled in parallel to the resonant tunneling diode to limit the maximum voltage that can develop across the resonant tunneling diode;

Fig. 6(b) illustrates the I-V characteristic curves for the circuit of Fig. 6;

Fig. 7 illustrates an alternative configuration to that shown in Fig. 4 and which utilizes bipolar transistors in place of FET transistors;

Fig. 8 illustrates yet another alternative configuration to that of Fig. 4; and

Fig. 9(a) illustrates a plan view and Fig. 9(b) is a vertical section taken along section line A-A of Fig. 9(a) of the manner of constructing the circuit of Fig. 4 in III-V GaAs or InP - based processing technologies.

### DETAILED DESCRIPTION

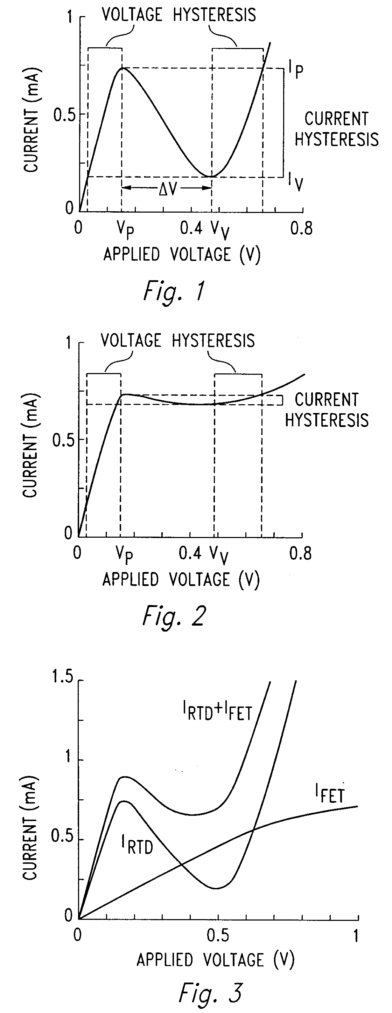

The Esaki tunnel diode and resonant tunneling diode (RTD) are examples of two-terminal negative-resistance devices which exhibit N-shaped current-voltage (I-V) relationship as shown in Fig. 1. As the voltage bias is increased across the two terminals of a tunnel diode, for example, the current initially increases monotonically from zero, then decreases sharply to a lower current typically three to 100 times lower than the peak current. Beyond this region of negative differential resistance, the current then increases again toward an exponential dependence on bias.

The application of both the tunnel diode and the RTD as load elements has been previously described e.g. K. Lehovec, IEEE J. Solid State Circuits SC-14, 797-800 (1979); K. Lear, et.al. Int. Symp. GaAs and Rel. Compounds, 593-598 Inst. Phys. Press (1988); and C. Chang, et. al, IEEE Electron Dev. Transactions 40 685-691 (1993). In these circuits designed for low power logic, the peak-to-valley current ratio (PVR) is made low to obtain a low power, but the low current of the tunnel diode limits the switching speed (since the voltage across the diode can change no faster than dV/dt=i/C, where C is the intrinsic capacitance of the device plus extrinsic capacitances associated with the output voltage node).

When a tunnel diode is used in a circuit the voltages and currents at which the diode makes a transition from peak-current to valley-current or from valley-current to peak- current differ. This difference is referred to as hysteresis (see Fig. 1). It is the purpose of this invention to describe a negative-resistance load element that yields a high speed switching characteristic and, in so doing, the current hysteresis is reduced as shown in Fig. 2. This I-V (current-voltage) behavior in RTDs can be produced by raising the valley current, by e.g. increasing the roughness of tunnel barrier interfaces, or introducing impurities into the double barrier heterostructure, or increasing the quantum well width to reduce the energetic separation of ground and first excited states. Similar approaches can be applied to the tunnel diode, or alternatively another negative resistance device with this negative-resistance I-V behavior can be used.

In circuits which utilize tunnel diodes, it is often desirable to have RTDs in one part of the circuit with high PVR (peak to valley current ratio) and also to have other RTDs in other parts of the circuit with a low PVR characteristic. To accommodate both types of devices on the same substrate, the low PVR characteristic can be obtained by parallel combination of a high PVR tunneling diode with an FET. The I-V characteristic of such a parallel combination is shown by the curve 10 in Fig. 3. The typical saturation voltage of a high speed transistor is between roughly 0.5 and 1V. When such a transistor is connected in parallel with an RTD having a peak voltage less than the saturation voltage of the transistor, the effect of the parallel combination is to increase the valley current of the tunnel device/transistor combination as illustrated in Fig. 3 generally at 12.

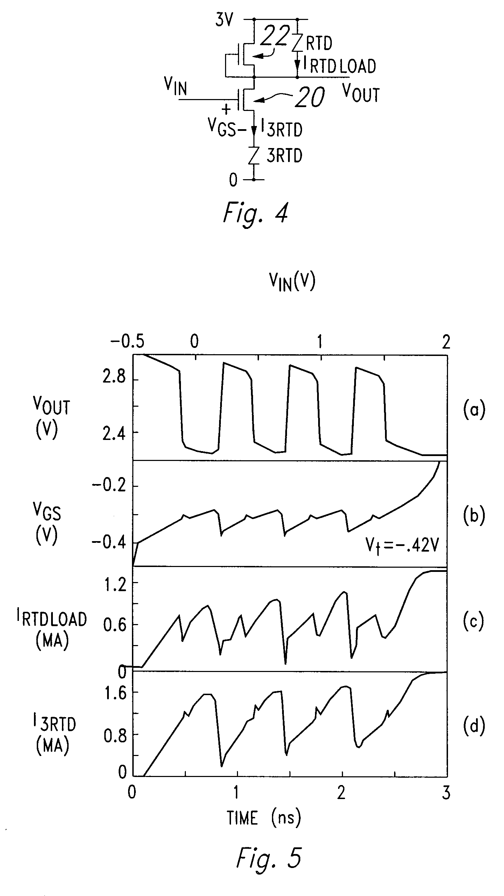

An example circuit which utilizes the RTD/transistor load is shown in Fig. 4. This circuit consist of depletion-mode field-effect N-type transistors and resonant tunneling diodes. The symbol labeled 3RTD refers to the series combination of 3 resonant tunneling diodes and RTD refers to a single RTD. These resonant tunneling diodes are usually constructed in the same manner so that they will have substantially the same I-V characteristic curve. A SPICE simulation of the input-output voltage relationship for the circuit of Fig. 4 is shown in Fig. 5(a) for a ramped input voltage from -0.5 to 2 V in 3ns. The circuit converts an analog input voltage to a binary output voltage. That is, the output voltage $V_{OUT}$ is either 2.8 volts or higher (a binary one) or 2.4 volts or less (a binary zero) for the various input voltages ranging from -0.5 to 2 volts. Figs. 5(b), (c), and (d) illustrate the gate/source voltage, $V_{GS}$, of the FET (with a threshold voltage $V_t$=-0.42 V); the current through the RTD load, $I_{RTDLOAD}$, and the current through the 3 RTD stack, $I_{3RTD}$ are also shown for the same input ramp signal mentioned above.

As the input voltage is increased from -0.5 V, the input transistor 20 begins to turn on as $V_{GS}$ exceeds its threshold voltage $V_t$ of -0.42 V. Current then increases through the load RTD until its current exceeds the RTD peak current at which point the voltage across the load RTD jumps up by approximately 0.4 volts giving rise to the first falling transition in the output voltage, $V_{OUT}$, from about 2.8 to about 2.4 volts. As input voltage continues to increase, the voltage across the 3RTD stack reaches its first peak and the 3RTD stack switches to a higher voltage. This causes $V_{GS}$ to decrease by about 0.4 volts, turning the input transistor 20 off and resetting the RTD load to its low voltage, low current state. The process then repeats again two more times as the input voltage continues to advance toward 2 V and through two additional switching transitions of the 3RTD stack.

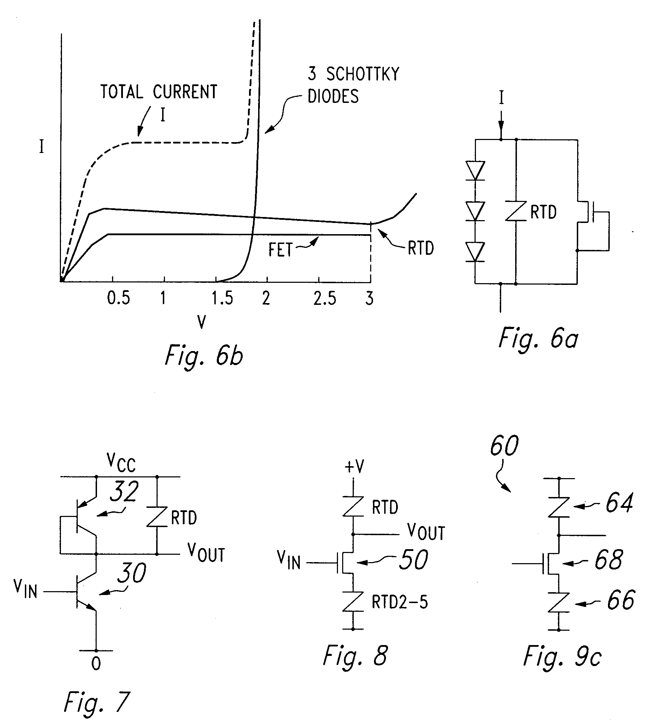

Resonant tunneling diodes with large valley voltage W can be used to increase the switching voltage, (DV) of the RTD/FET load. For a large switching voltage (2-4 volts), it is possible to use parallel Schottky diodes to clamp the switching voltage to a multiple of the number of Schottky diodes used as illustrated in Figs. 6a and 6b.

Fig. 7 illustrates an alternative configuration to that shown in Fig. 4. In this embodiment of the invention, the transistors 20 and 22 of Fig. 4 are replaced in Fig. 7 with bipolar NPN transistor 30 and PNP transistor 32. Otherwise the circuit configuration of Fig. 7 is the same as Fig.4. In operation, the circuit of Fig. 7 functions in the same manner as does the circuit of Fig. 4, however, the voltages of operation may be somewhat different due to the fact that bipolar transistors are used instead of FETs.

Fig. 8 illustrates yet a further alternative to that shown in Fig. 4. This configuration includes an input N-type FET transistor 50 with its gate connected to receive an input signal $V_{IN}$. The drain of transistor 50 is coupled through a resonant tunneling diode $RTD_1$ to a positive voltage source V. The source of transistor 50 is coupled through three series connected resonant tunneling diodes designated $RTD_{2-4}$ to ground. This circuit will function in the same manner as the circuit of Fig. 4 if the peak-to-valley current ratio (PVR) of $RTD_1$ is less than the peak-to-valley current ratio of each of the resonant tunneling diodes designated $RTD_{2-4}$. In general, it has been shown in circuit simulation that it is desirable for the PVR of $RTD_1$ to be less than 2 and preferably quite close to 1. On the other hand, the PVR for each of the resonant tunneling diodes designated $RTD_{2-4}$ is desired to be at least 2 or greater. As noted above, the PVR for a given resonant tunneling diode can be controlled in the manufacturing process so it is readily possible to achieve these desired PVRs.

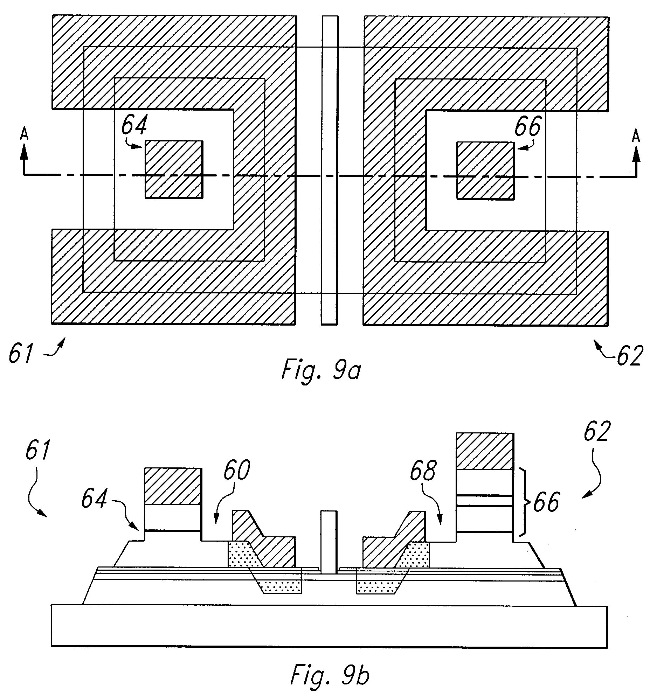

Figs. 9a-9c illustrates the manner in which the present invention can be implemented in III-V circuit technology. A similar scheme can also be readily devised for Si bipolar or MOS technologies. The two FET transistors comprising the circuit of Fig. 4 are positioned on the substrate closely adjacent each other. In Figs. 9a and 9b, the configuration of the input FET and the two RTDs are indicated generally at 61. The load resonant tunneling diode 64 is constructed on top of transistor 60 and the series connected tunneling diodes 66 are constructed vertically above transistor 68. Accordingly, in this implementation of the present invention, one can readily see how the objective of producing a circuit which is physically small in size has been achieved for the circuit of Fig. 4, for example, needs only take up substantially the space for two FET transistors on a substrate since the tunnel diodes can be vertically integrated onto the source or drain terminals of the FET. Power consumption is kept to a minimum due to the use of low power components in this circuit as well.

It should also be noted that in connection with the circuit of Fig. 4, the PVR for all of the resonant tunneling diodes in the circuit can in fact be substantially the same. This is possible by reason of the fact that the load resonant tunneling transistor RTD is shunted by a transistor 22 which causes the effective PVR for the combined RTD and transistor 22 to be less than the PVR for any one of the three resonant tunneling diodes 3RTD.

The above description has concentrated on the theory of operation and circuit diagrams for the illustrated implementations of the present invention. One readily apparent modification to the illustrated circuits is to change the number of resonant tunneling diodes series connected together between the source of transistor 20 and ground. Specifically, only one such resonant tunneling diode is required for the circuit to be functional. The number of such resonant tunneling diodes, however, controls the number of transitions that can exist in the voltage in - voltage out curves of the type illustrated in Fig. 5a. A further alternative design is possible where the NPN or N-type transistors are replaced by PNP or P-type transistors. In this alternative design, appropriate changes for the power supply are required. A further alternative is to replace the resonant tunneling diodes with any other device or circuit which exhibits a negative-resistance characteristic of the general type illustrated in Fig.1. Appropriate PVRs for these devices as discussed with respect to Fig. 8 must be maintained in all possible alternative designs in order to make the circuit function as illustrated in Figs. 5a-5d. These and other modifications to the specific circuit diagrams illustrated herein may be readily made without departing from the spirit and scope of the present invention.

## Claims

1. A circuit responsive to a multi-valued input signal for producing an output at only two states comprising, in combination:

   a transistor with a control electrode and first and second current guiding electrodes;
   a first negative-resistance element coupled between said first current guiding electrode and a first terminal of a power source, said first negative-resistance element having a first peak to valley current ratio of M; and
   a second negative-resistance element coupled between said second current guiding electrode and a second terminal of said power source, said second negative-resistance element having a peak to valley current ratio of greater than M.

2. The circuit as claimed in Claim 1, wherein said first negative-resistance element comprises;

   a further transistor with a control electrode and two current guiding electrodes, said control electrode of said further transistor being coupled to one of said current guiding electrodes; and
   a negative-resistance device connected between said two current guiding electrodes of said further transistor, the peak-to-valley current ratio of said further transistor shunting said negative-resistance device.

3. The circuit as claimed in Claim 2, wherein said negative-resistance device comprises a resonant tunneling diode.

4. The circuit as claimed in any preceding claim, wherein said second negative-resistance element comprises at least one resonant tunneling diode.

5. The circuit as claimed in any of Claims 1 to 3, wherein said second negative-resistance element comprises at least one esaki diode.

6. The circuit as claimed in any preceding claim, wherein said first negative-resistance element comprises at least one resonant tunneling diode.

7. The circuit as claimed in any of Claims 1 to 5, wherein said first negative-resistance element comprises at least one esaki diode.

8. The circuit as claimed in any preceding claim, wherein said transistor is a field effect transistor (FET).

9. The circuit as claimed in any of Claims 2 to 8, wherein said further transistor is a field effect transistor (FET).

10. The circuit as claimed in any of Claims 1 to 7 wherein said transistor is a bipolar transistor.

11. The circuit as claimed in any of Claims 2 to 7, wherein said further transistor is a bipolar transistor.

12. A circuit responsive to a multi-valued input signal for producing an output at only two states comprising, in combination:

at least two negative-resistance elements connected in series forming a two terminal device, one said terminal connected to a first electrical potential;
a first transistor with a control electrode and two current guiding electrodes, said control electrode being connected to an input terminal for receiving the multivalued input signal, one current guiding electrode being connected to the circuit output, the remaining current guiding electrode being connected to one terminal of said two terminal device;
a second transistor with a control electrode and two current guiding electrodes, said control electrode of said second transistor and one current guiding electrode of said second transistor being connected to said output, the remaining current guiding electrode of said second transistor being connected to a second electrical potential; and
a second negative-resistance element connected between said output and said second electrical potential, the characteristics of said negative-resistance elements and said transistors being such that the peak-to-valley current ratio for said second negative-resistance element and said second transistor being less than the peak-to-valley current ratio of any said negative-resistance elements coupled between said first electrical potential and said first transistor.

13. The circuit as claimed in Claim 12, wherein each said negative-resistance element comprises a resonant tunneling diode.

14. The circuit as claimed in Claim 12, wherein each said negative-resistance element comprises an esaki diode.

Fig. 1

Fig. 2

Fig. 3

Fig. 4

Fig. 5

EP 0 774 839 A2

Fig. 6b

Fig. 6a

Fig. 7

Fig. 8

Fig. 9c

Fig. 9a

Fig. 9b